# EUROPEAN PATENT APPLICATION

(11) **EP 3 316 351 A1**
(43) Date of publication of application: **02.05.2018**
(21) Application number: 16195961.4
(22) Date of filing: 27.10.2016
(51) Int. Cl.: H01M 2/34, H01M 10/42, H01M 10/052

(54) **A SYSTEM AND A METHOD FOR TESTING A BATTERY CELL**

(71) Applicant: Lithium Energy and Power GmbH & Co. KG, 70469 Stuttgart (DE)
(72) Inventor: HILLER, Martin Manuel, 70469 Stuttgart (DE); FUCHS, Franz, 70191 Stuttgart (DE)
(74) Representative: Bee, Joachim

(57) **Abstract**

A system (1) for testing a cell by creating at least one short circuit, particularly a defined internal short circuit, within the cell, comprising at least one cathode (4) and at least one anode (2), and at least one separator (3), which is adjustable between the cathode (4) and the anode (2) of the cell, whereby at least the cathode (4) comprises a pad (5) able to emit metal ions, which enable the growth of at least one dendrite (6).

## Description

The invention relates to a system for testing a cell by creating at least one short circuit according to independent apparatus claim and a method for testing a cell by creating a short circuit according to independent method claim.

### State of the art

Several cell chemistries like nickel-metal hydride lithium-ion secondary cells, lithium-ion primary cells etc. and designs like button cells, cylindrical, prismatic, stacks etc. are available in the market. A conventional design of a large lithium-ion cell normally consists of jelly rolls or stacks that are connected to current collector tabs and the complete assembly is sealed hermetically in an aluminum or steel can. Before assembly of the single cells in a cell pack, individual cells are coated with plastic tapes or coated with electronically non-conductive paint. This is done in order to avoid electrical contact between different cells in a cell pack and hence a short circuit within the system.

### Disclosure of the invention

A system according to the invention for testing a cell by creating at least one short circuit, particularly defined internal short circuit within the cell, comprises at least one cathode and at least one anode. Further, the system comprises at least one separator which is adjustable between the cathode and the anode of the cell. Thereby, at least the cathode comprises a metal pad being able to emit metal ions into the electrolyte which enables the growth of at least one dendrite. Preferably, the pad is not electronically connected to the cathode but rather isolated from the cathode. In general, batteries consist of a cathode electrode which is the positive electrode, wherein the cathode emits electrons through an outer circuit to the anode, and an anode electrode, which is a negative electrode, wherein the anode accepts electrons. Further, a separator is electronically isolating the cathode from the anode. Preferably the cell can represent a lithium-ion cell, whereby during the charging of the lithium-ion cell the lithium ions are migrating from the cathode across the separator to the anode simultaneously with an electron flow in the same direction on an external circuit. During the discharging the same process occurs in the opposite direction such that lithium-ions are migrating from the anode across the separator to the cathode. Further, at least the cathode according to the invention comprises a pad able to release metal ions into the electrolyte. Besides it is possible that also the anode comprises a pad able to emit metal ions and/or the separator comprises at least one pad able to emit metal ions. Generally, the pad can be positioned at the edge of the electrode and/or at the intermediate section. Advantageously, the pad can be positioned within stack cells and/or jelly rolls.

If certain metal contaminations are introduced into a cell during the production processes, dendrites can be formed from metal ions emitted by the electrochemically oxidized particles which migrate as ion to the anode to be electrochemically reduced to the metal state. The dendrites preferably grow from the anode to the cathode. An electrical short circuit can be created in the cell as soon as the dendrites connect the anode to the cathode. Such internal electrical short circuits are potentially critical and may lead to a thermal runaway of the electro-chemical cell. Preferably, a sensor technique can be developed to detect a short circuit to preferably guide the cell in a safe state before the short circuit becomes critical. By testing and characterizing such a short circuit, the growth of dendrites enables a determination. By forming dendrites with the proposed technique/method, a defined creation of a short circuit could be established at a desired time to test a developed short circuit in an easy way.

Further features and details of the invention result from the dependent claims, the description and the drawings. Thereby, the features and details which are described corresponding to the system according to the invention naturally also apply corresponding to the method according to the invention and vice versa, so that according to the disclosure of the single aspects of the invention, it can always be reciprocally related to.

In order to generate a dendrite growth, metal ions are necessary in the electrolyte. These ions can be generated via electrochemical oxidation of certain metals in the cell. These metals can at least be placed on the cathode previous of the formation of the cell. During the production and/or during the first charging and/or a further charging of the cell, the dendrites can be created. Preferably, dendrites are created from metal ions emitted by a metal pad which is electrochemically oxidized. Thereby the ions go into solution and diffuse towards the anode where they are reduced and can establish a dendrite. The pad can be configured as a stripe, a tape, a metal sheet, a small plate, and/or a platelet or suchlike. Advantageously, an internal short circuit is created by an internal event like the growth of dendrites and not by an external electric and/or mechanical stimulus like a nail penetration. Advantageously, this system can be implemented in all different cell types from stacked layer cells to prismatic cells with jelly rolls. Thereby the system is compatible for prismatic jelly rolls which are made by rolling elements together which are particularly a cathode active material coated on a metal foil and an anode active material on another metal foil and a separator and which are all soaked in electrolyte. Further, for a stacked cell several of the double-sided coated electrode sheets are put on top of one another and for example are sealed in a pouch which configures stacked type cells. By a determination of the position of the metal pad emitting the metal ions during oxidation, the position of the internal short circuit within the cell can be set. Positions in the middle of the electrode as well as at the edge of the electrode are possible. The positions in an inner or an outer electrode layer of the cell can be varied. By choosing the size of the pad emitting the metal ions into solution, the size of the area of dendrite growth and thus the size of this created internal short circuit can be directly influenced and determined. Thereby, it can be advantageous when the size of the metal pad is matched to the size of possible contamination particles in order to achieve a realistic dendritic internal short circuit. Due to its initial electronic isolation of the pad against the cathode and the electric connection of the metal pad which is guided outside of the cell, the short circuit can be triggered at any time by increasing the potential of the metal pad using the electric connection towards oxidative potential. Consequently, it is possible to initially cycle and characterize a healthy cell and subsequently cause an internal short circuit at a desired time. The exact potential value and potential over time profile of the metal pad against the anode or cathode can be chosen freely. Consequently, the dissolution rate of the metal pad and thus the rate of emitted metal ions can be directly determined and controlled. Thus, for example also a stepwise growth of dendrites leading to an internal short circuit can be achieved.

An advantage of the present system is thereby, that this internal short circuit trigger is able to create realistic internal short circuits in cells, particularly in lithium-ion cells, on demand. In contrast to other techniques to intentionally create an internal short circuit, the healthy cell can be initially characterized previous to the short circuit and subsequently an internal short circuit can be created at a desired time without the need to heat the cell up in order to generate a short circuit. Using this technique, developed detection and actuation mechanisms can be tested and the effects of a realistic internal short circuit can be investigated. Furthermore, the extent of dendrite growth which is in a real cell can be influenced by the exact amount of metal contamination present and which can lead to a particular internal short circuit can be determined and controlled with the proposed device and testing method. Furthermore, even the exact location of the induced internal short circuit can be chosen via the positioning of the metal pad emitting the metal ions. Thereby, the dendrites can be created in the center of one electrode layer, but also at the edge of the electrode layer where the internal short circuit may be more critical. The positions in an inner or an outer electrode layer of the cell are variable. Advantageously, this test method can be applied to all kinds of cell formats in order to perform cell safety testings.

Further, it is possible within the scope of the present invention that a short circuit between the cathode and the anode can be provoked by the growth of at least one dendrite from a pad emitting metal ions. Said emitted metal ions result from a metal pad forced at oxidative potential and preferably located at least at the cathode. Particularly, due to an increase in the (electrical) potential of the pad, metal ions are emitted from the pad, which is electrochemically oxidized. These metal ions are able to grow a dendrite. Particularly, the dendrites can grow from the metal ions in solution that are reduced at the anode. Thus, the dendrites are preferably growing from the anode towards the cathode. Due to this dendrite growth, a connection between the cathode and the anode can be generated wherein an internal short circuit can be established.

Preferably, the metal pad is electronically isolated from at least the cathode wherein the electronic isolation is particularly achieved by a gap between the cathode and the metal pad and/or an isolating layer, particularly a separator sheet between the cathode and the metal pad. The metal ions are particularly emitted metal ions from a pad wherein the pad can be located at least at the cathode. Thereby, the metal pad does not necessarily comprise a direct contact to the cathode but can be electronically isolated. This isolation can be due to a separation in form of a gap or an isolation or a paint or a glue or any other substance which separates the pad, which emits the metal ions, from the cathode. Preferably, the pad is separately contacted by a wire which is guided outside of the cell. By an increase of the potential of the pad, via the external electric connection, the metal ions are emitted from the pad via electrochemical oxidation of the pad. Thereby the electric isolation is overcome via the external electric connection. Thereby, a contact of the metal pad to the electrolyte is preferred in order to produce metal ions emitted into the electrolyte on demand. However, an electric contact to cathode or anode is preferably avoided via isolation.

Preferably, the dissolving metal ions are at least from copper and/or iron and/or nickel and/or manganese and/or lithium and/or cobalt and/or lead and/or zinc and/or tin. Thereby, said ions can be homogenously from just one metal or from a combination of multi metals.

Copper comprises a high electric conductivity, high thermal conductivity and further a low hardness and high ductility of single crystals. Besides copper is easy to handle and a good source of single metal ions. Iron is a flexible metal which can comprise different degrees of hardness and/or softness depending on the purity of the metal-ions and is further resistant to high pressures and temperatures. Therefore, iron is easy to handle and cost efficient to use. Nickel is thereby resistant to corrosion and oxidizes very slowly at room temperature. Therefore, nickel is resistant and long lasting to use. Manganese is a hard metal which is easy to oxidizes and hard to form. Therefore, manganese is a resistant metal comprising robust properties. Lithium is a very light material as a dense solid chemical element. Lithium is further highly reactive and flammable. Preferably, lithium has a single valence electron that is easily given up to form a cation and therefore lithium is a good conductor of heat and electricity as well as a highly reactive element. All these metals can occur as contamination within the cells. Cobalt is a resistive metal with a high electric conductivity. Lead, zinc and tin are metals which can be formed easily. Further, Lead is a protector from oxidation.

Further, it is possible within the scope of the invention the pad is able to emit metal ions when its potential is raised over the redox potential of the pad. Particularly, the potential between the metal pad and the anode is approximately between approximately 0 V and approximately 6 V, particularly between approximately 1 V and approximately 5 V, preferably over approximately 1,5 V. Therefore, the potential of the formerly stable metal pad can be raised towards oxidative potential, for example the one of the cathode, and subsequently the metal dissolution can start while its potential can raise over the redox potential of the pad. Further, preferably the exact amount of dissolving metal ions can be determined, therefore the needed amount for an internal short circuit can be analyzed.

Preferably, the dendrites produced by the pad emitting metal ions comprises a size of the diameter of approximately 5 nm to approximately 10 mm, particularly of approximately 250 nm to approximately 900 nm, preferably of approximately 300 nm to approximately 800 nm. This size of a diameter can be preferably sufficient to allow a connection such that a sufficient internal short circuit can be generated to discharge the cell or even leads to a thermal runaway of the cell.

Preferably, the extension, particularly the length of the produced dendrites ranges from approx. 1 µm to approx. 50 µm, particularly from approx. 5 µm to approx. 30 µm, preferably from approx. 8 µm to approx. 20 nm. This extension can be preferably sufficient to circumvent the electric isolation and create a connection between the cathode and the anode such that an internal short circuit can be generated.

Another aspect of the present invention is a method for testing a cell by creating a short circuit, particularly a defined short circuit within a cell with at least one cathode and at least one anode and at least one separator which is adjustable between the cathode and the anode. Thereby, the method comprises the following steps:
a) Placing a pad, able to emit metal ions, at least on the cathode during the production of the cell and/or during a first charging of the cell and/or after the first charging of the cell,
b) creating the internal short circuit between an anode and a cathode by a pad of emitting metal ions,
c) testing the functional range of the cell.

The metal pad emitting the metal ions can serve as a source of metal ions for growing a dendrite. Due to the growth of the dendrites, a connection between the anode and the cathode can be established such that an internal short circuit can result. The creation of the internal short circuit between the cathode and the anode by a metal pad can be due to the raising of the potential of the metal pad towards oxidative potentials (e.g. the potential of the cathode) such that the metal ions can start to go from the pad into solution. Due to the possibility of determination of where and when and due to what potential an internal short circuit within the cell can be created, the functional range of the cell can be determined. Further, the functional range of the cell can be compared to normal cells as well as to contaminated cells in order to evaluate the determined values in comparison to reference values.

Further, it is conceivable that in a step b.1) the potential of the metal pad can be raised above the equilibrium potential of the pad. Preferably, above approx. 3 V above Li-Potential. Particularly, the metal pads potential can be raised towards the potential of the cathode. Due to raising the potential of the metal pad, the metal ions can be generated from the pad and can freely go into the electrolyte within the cell such that they can start to grow dendrites at the anode. Preferably, the dissolution of the pad can be an electrochemical oxidative dissolution of a metal pad which is then converted into metal ions.

Further, it is possible with the method according to the invention, that in a step b.2) the metal ions emitted from the pad can diffuse towards the anode wherein particularly the metal ions can create at least one dendrite at the anode which can grow towards the cathode. Thereby, a connection between the cathode and the anode can be established. Due to this connection the separation and therewith isolation between the cathode and the anode can be compensated such that an internal short circuit can be generated. Thereby, in a first stage of the cell the metal pad is not forced to an oxidative potential via the external electric connection, for example by electric connection to the cathode. The formation and characterization of a healthy cell can be performed without disturbances. In a second stage the external electric connection between the metal pad and the cathode can be established, the potential of the formerly stable pad can be raised towards oxidative potentials and the metal dissolution can start when its potential is raised over approximately 3.4 V vs. lithium. Via the measurement of the current over the external electric connection, the exact amount of emitted metal ions can be determined. The metal ions can thereby diffuse towards the anode where they can get reduced and create metallic dendrites. These dendrites can grow through the separator until they reach the cathode and the metal pad which can be on the potential of the cathode. Thereby an internal short circuit can be created. The creation of the internal short circuit can be detected via a sudden increase of the current over the metal pads external electric connection and potentially via spikes on the cell voltage and the starting discharge of the cell. The metal dissolution may be stopped at any time by interrupting the external connection between the pad emitting the metal ions and the cathode, or in general by reducing the metal pads potential towards lower and reductive potentials.

Moreover, a safety testing procedure regarding internal short can be established by building-up the cell with in internal short circuit trigger and a characterization of the healthy cell wherein no internal short circuit is produced yet and the metal pad is isolated against cathode and at a non-oxidative potential. Via an external connection to the metal pad, the metal pad is brought to an oxidative potential whereby the metal ions are produced. Thus, dendrites are growing from the anode to the cathode and can establish an internal short circuit. Preferably, the creation of an internal short circuit and a reaction of the cell facing the internal short circuit is monitored.

The steps of the method can be preferably executed in any order, however preferably in an alphabetic order from a) to b), a) to c) or b) to c).

Further advantages, features and details of the invention result from the following description in which with reference to the drawings the embodiments of the invention are described in detail. Thereby, the feature described in the claims and in the description can be each single or in every combination essential for the invention. It is shown:

Figure 1:
- Figure 1a: a schematic illustration of the edge region of one electrode layer of the cell according to the invention
- Figure 1b: a schematic illustration of the middle section of one electrode layer of the cell according to the invention
- Figure 1c: a schematic illustration of the edge region of one electrode layer of the cell according to the invention
- Figure 1d: a schematic illustration of the middle section of one electrode layer of the cell according to the invention
- Figure 2: a schematic illustration of the method according to the invention.

In the different figures the same features always correspond to the same reference signs, therefore generally the features are only described once.

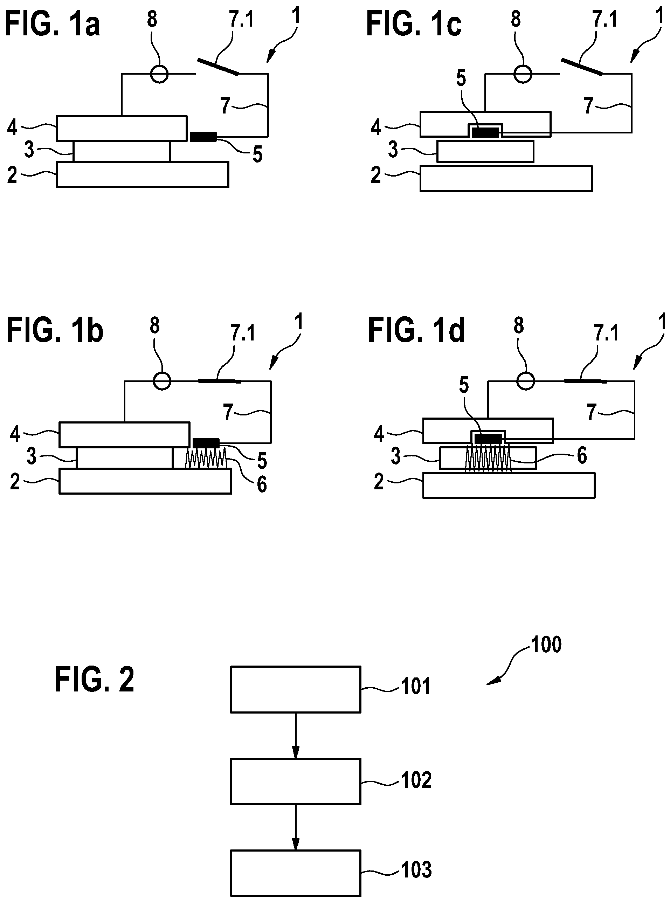

Figure 1 shows a system 1 for testing a cell comprising at least one cathode 4 and at least one anode 2 and at least one separator 3 which is adjustable between the cathode 4 and the anode 2. Further, the system comprises a metal pad 5, able to emit metal ions, which is preferably located at the cathode 4. The pad 5 can thereby comprise any geometrical design, preferably comprising an extended surface, like for example in the shape of a spiral or foil. Moreover, the system comprises an external electric connection 7 with a switch 7.1 and a current measuring device 8, particularly an ampere meter. Thereby, the cell can be configured as a jelly roll consisting of a cathode electrode active-material coated on a metal foil as a positive electrode and an anode electrode active-material on another metal foil as a negative electrode and a separator soaked in electrolyte. A prismatic jelly roll is made by rolling these elements together. For a stacked cell several of the double-sided coated electrode sheets are put on top of each other and for example are sealed in a pouch which can configure a pouch cell. Here figures 1a and 1c schematically represent a pad in the edge section of one electrode layer to create an edge case internal short and figures 1b and 1d schematically represent a pad in the middle section of one electrode layer of a cell to create an internal short in the middle of the electrode layer. This can be applied to all kinds of cell formats, preferably stacks and/or jelly rolls. Thereby an electrically connected metal pad can be placed on the cathode side of the electrode stack, here for example a pad from copper. Thereby, the pad is able to emit metal ions. Preferably, the pad has to be electronically isolated from the electrodes which is either achieved be leaving a gap between the electrodes and the pad or by isolating the pad via a thin separator sheet from the electrodes. Further, it is possible to separate the pad from the electrode conceivable like for example a gap or an insulating material. Figure 1a thereby shows the system with in an inactive state and no external current.

Figure 1c shows the system, particularly the pouch cell in an activated mode wherein the switch 7.1 is closed such that the current can flow through the external electric connection 7. Due to this electric connection, the potential of the pad is raised towards the potential of the cathode and the emission of the metal ions from the pad 5 arises. These emitted metal ions start to grow dendrites 6 at the anode 2. The current over the electric connection between cathode and the dissolving metal pad can be measured by the current measurement device 8.

The flown charge over this connection directly relates to the amount of produced metal ions emitted into the electrolyte. In the case of for example copper, according to the following equation: Cu -> Cu²⁺ + 2 Electrons. The metal ions can then cause dendrites 6 that grow from the anode 2 through the separator 3 towards the cathode 4 and establish a connection between the anode 2 and the cathode 4. Thereby, the location of the internal short inside the cell is determined by the position of the metal pad. Furthermore the severity of the internal short may relate to the amount of produced dendrites and thus emitted metal ions from the pad. The latter is controlled via the applied potential of the metal pad and the length of time the pad is forced to this higher, oxidative potentials (the amount of charge flowing from the pad to the cathode correlates directly to the amount of dissolved Cu). Consequently also the severity of the internal short may be directly influenced.

Figure 1b shows an electrode layer with the metal pad able to emit metal ions with the pad located in the middle section of the electrode layer and the internal short trigger in an inactive mode. The pad 5 able to emit metal ions is located on/within the cathode 4 but is separated from the cathode 4 by for example a gap or an isolating material.

Figure 1d illustrates an electrode layer with the metal pad able to emit metal ions in the middle section of the electrode layer. The metal pad is connected via an external electric current to the cathode 4. The potential of the metal pad is this way forced to higher oxidative values (the potential of the cathode). Thereby the metal pad is oxidized and metal ions are released from the pad 5 and can diffused to the anode 2 and grow at least one dendrite 6 at the anode 2. Thereby the dendrite 6 grow from the anode 2 into the direction of the pad 5 and the cathode 4 by overcoming the separator 3 such that the connection between the anode 2 and the cathode 4 is established. The amount of emitted metal ions able to grow these dendrites can be determined from the amount of charge flowing over the external electric connection between metal pad 5 and cathode 4 until an internal short circuit is produced. When an internal short circuit is established the current over the metal pads external connection will rise suddenly due to the flowing short circuit current. The internal short circuit can also cause a drop in the cell voltage.

Preferably, the metal pad can be used with a defined size and weight. Further, in the case of a pouch cell, the metal pad 5 can be fixed (in close proximity to the cathode 4) via ultrasonic welding to a nickel tap which also represents an electric connection to the metal pad on the outside of the cell. In all cell formats, another possibility to fix the metal pad 5 is for example by the use of tape or isolating glue.

Further, it is possible to influence the magnitude of the internal short circuit by the configuration of the pad 5 able to emit metal ions. This can for example be achieved by the size of the area of the pad exposed to the electrolyte or by the chosen potential of the pad 5. Also defined potential/current over time functions could be applied as for example potential sweeps or pulses. For instance, the current pulse would allow to emit a defined amount of metal ions to subsequently observe its effect and then to pulse again to further advance the dendrite 6 growth. The pad 5 may also be utilized when it is located at the anode 2 but electrically isolated from the anode 2. By increasing the metal pads potential towards oxidative potentials (e.g. the one of the cathode), also metal ions are emitted from the pad 5 and an internal short circuit can be created between anode and cathode. Via the size of the exposed metal pad and the temporal length of the electrical connection between the pad 5 and the cathode 4, the amount of emitted metal ions can be influenced. Consequently, the extent of the dendrite 6 growth and the resistance of the internal short circuit can be regulated. Thereby, the form of the dendrites 6 can vary, preferably single dendrites and dense dendrite networks/webs 6 can be created. For a weak connection of anode and cathode via a single dendrite, only a soft short circuit comparable to an increased self-discharge of the cell is caused. However, a dense network of dendrites 6 leads to a strong cell discharge over prominent internal short circuit. By energy dispersive x-ray-spectroscopy (EDX) the structures of the dendrites can be examined. Typically, the diameter lies between approx. 5 nm and approx. 10 mm and the length of the dendrites connecting anode and cathode has to be at least equal or bigger than the thickness of the separator.

Figure 2 shows the flowchart displaying a method 100 according to the present invention. The method 100 can preferably start with a placing 101 of a pad 5 of able to emit metal ions on at least one cathode 4. Preferably, the pad 5 is thereby isolated from the cathode 4. This placing 101 occurs preferably during the production of the cell and/or during a first charging of the cell and/or after a first charging of the cell. In a further step a creating 102 of the internal short circuit between an anode 2 and a cathode 4 by a metal pad 5 emitting metal ions is induced. This is induced by generating an external electric connection between the metal pad 5 and the cathode 4. Thereby, the metal pad is oxidized and emits metal ions from the pad 5 into solution which diffuse towards the anode 2. Said emitted metal ions result from a metal pad 5 which is preferably located at least at the cathode 4. Particularly, due to an increase in the (electrical) potential of the pad 5, metal ions can be emitted from the pad 5 wherein these metal ions are able to grow a dendrite 6. Particularly, the dendrites 6 can grow from the metal ions in solution that are reduced at the anode 2. Thus, the dendrites 6 are preferably growing from the anode 2 towards the cathode 4. These ions can further grow dendrites 6 at the anode 2 whereby the dendrites 6 grow into the direction of the cathode 4, the insulation/separation is overcome and the connection between the anode 2 and the cathode 4 via the dendrites 6 is established. In a further step the testing of the functional range of the cell can occur. This testing 103 can for example be performed by using a cell voltage measurement, surveillance of the cell temperature at different location of the cell, observation of the hazard level in the case of safety critical event like fire or explosion caused by the created internal short circuit. The amount of emitted metal ions from the pad 5, can be related to real metal contaminations in a real manufacturing process. The observed cell reaction during the testing 103, can then be related to the possible safety critical effects of real metal contaminations in cells during cell production.

The method described in figure 2 can particularly be realized with a system of the embodiments shown in figure 1.

The previous description of the embodiments describes the present invention only within the scope of examples. Naturally, also single features of the embodiments as far as they can be meaningful can be freely combined with one another without leaving the scope of the invention.

## Claims

1. A system (1) for testing a cell by creating at least one short circuit, particularly a defined internal short circuit, within the cell, comprising at least one cathode (4) and at least one anode (2), and at least one separator (3), which is adjustable between the cathode (4) and the anode (2) of the cell,
**characterized in that**,
at least the cathode (4) comprises a pad (5) able to emit metal ions, which enable the growth of at least one dendrite (6).

2. The system (1) according to claim 1,
**characterized in that**,
a short circuit between the cathode (4) and the anode (2) can be provoked by the growth of at least one dendrite (6) of the pad (5) emitting metal ions.

3. The system (1) according to claim 1 and 2,
**characterized in that**,
the pad (5) able to emit metal ions is electronically isolated from at least the cathode (4), wherein the electronical isolation is particularly achieved by a gap between the cathode (4) and the pad (5) of dissolving metal ions and/or by a thin separator sheet between the cathode (4) and the pad (5) able to emit metal ions.

4. The system (1) according to one of the proceeding claims,
**characterized in that**,
the emitted metal ions are from at least one of the following: copper, iron, nickel, manganese, lithium, cobalt, lead, zinc, tin or a combination thereof.

5. The system (1) according to one of the proceeding claims,
**characterized in that**,
the size of the pad (5) able to emit metal ions is selectable and/or the location of the pad (5) able to emit metal ions is selectable.

6. The system (1) according to one of the proceeding claims, **characterized in that**, the pad (5) is able to emit metal ions when its potential is raised over the redox potential of the pad (5).

7. The system (1) according to one of the proceeding claims,
**characterized in that**,
the dendrite (6) comprises a diameter of approximately 100 nm to approximately 1 200 nm, preferably of approximately 250 nm to approximately 900 nm and more preferably of approximately 300 nm to approximately 800 nm.

8. A method (100) for testing a cell by creating a short circuit, particularly a defined internal short circuit, within the cell with at least one cathode (4) and at least one anode (2), and at least one separator (3), which is adjustable between the cathode (4) and the anode (2), comprising the following steps:
a) Placing (101) a metal pad (5) able to emit metal ions on at least one cathode (4) during the production of the cell and/or during a first charging of the cell and/or after a first charging of the cell,
b) Creating (102) the internal short circuit between the anode (2) and the cathode (4) by a pad (5) able to emit metal ions,
c) Testing (103) the functional range of the cell.

9. The method (100) according to claim 8,
**characterized in that**,
in a step b.1) the potential between the metal pad (5) and the anode (2) is raised towards oxidative potentials.

10. The method (100) according to claim 8 or 9,
**characterized in that**,
in a step b.2) the metal ions of the pad (5) emitting metal ions are diffusing towards the anode (2), wherein particularly the metal ions create at least one dendrite (6) at the anode (2) which is growing towards the cathode (4), wherein a connection between the cathode (4) and the anode (2) is established.
